# EUROPEAN PATENT SPECIFICATION

(11) **EP 1 211 802 B1**
(45) Date of publication and mention of the grant of the patent: **07.05.2008**
(21) Application number: 00126287.2
(22) Date of filing: 01.12.2000
(51) Int. Cl.: H03D 7/16

(54) **Filter with tunable bandwidth using two frequency translators**
Filter mit abstimmbarer Bandbreite unter Verwendung von zwei Frequenzumsetzern
Filtre à largeur de bande réglable utilisant deux dispositifs de translation de fréquence

(43) Date of publication of application: 05.06.2002
(73) Proprietor: Sony Deutschland GmbH, 10785 Berlin (DE)
(72) Inventor: Nöthlings, Rolf, c/o Adv. Techn. Center Stuttgart, 70327 Stuttgart (DE); Wildhagen, Jens, c/o Adv. Techn. Center Stuttgart, 70327 Stuttgart (DE)
(74) Representative: Müller - Hoffmann & Partner

(56) References cited:
- DE-A- 3 031 190
- GB-A- 2 183 970
- GB-A- 2 322 984
- US-A- 5 390 346
- US-A- 5 613 234

## Description

The present invention relates to a filter with tunable bandwidth, in particular a digital filter with tunable bandwidth, and a method to perform tunable bandwidth filtering.

Such a filter is particularly suited to be comprised in an AM receiver, in particular to such AM receivers which comprise an IF-filter with a fixed IF-bandwidth.

Generally, in broadcasting adjacent channels can cause problems in the reception of the wanted channel, especially when they have high energy. Such adjacent channels even can disturb the wanted channels by overlapping in the frequency domain. In such a case the bandwidth of the wanted signal has to be reduced in the receiver to suppress the disturbing adjacent channel.

For this purpose, common receivers comprise a set of audio filters with different bandwidths wherefrom one is chosen to filter the received signal. As these filters are discrete realizations usually not the optimal bandwidth for the actual reception situation is provided, i. e. either the bandwidth is to big and therefore the adjacent channel is not suppressed sufficiently, or the bandwidth is to small and therefore information gets lost unnecessarily.

European Patent Application 00 110 526.1 filed by the Applicant which content is herewith included by reference into this specification discloses an AM receiver with at least one IF-filter with a fixed IF-bandwidth and which comprises at least one down conversion stage to shift the signal input thereto into an IF range having a variable oscillation frequency which is adjustable to tune a wanted center frequency of a wanted signal part from a center frequency of said at least one IF-filter so that an unwanted signal part adjacent to said wanted signal part lies outside said fixed IF-bandwidth. Therewith, the actual reception situation can be considered to just suppress the disturbing adjacent channel and therefore prevent unnecessary information loss.

However, in case that both adjacent channels should be sufficiently suppressed in the baseband signal without unnecessary information loss according to the teaching of the above-identified application two sharp complex filters and three complex mixers are needed which means that a considerable amount of calculation power has to be reserved for the realization of the filter with tunable bandwidth.

In addition, document DE 30 31 190 A discloses a filter according to the preamble of claim 1. Therefore, it is the object underlying the present invention to provide a filter with tunable bandwidth and a method for filtering an input signal with a comparatively decreased calculation power.

This object is solved according to the present invention by the filter characterized in independent claim 1 and the method characterized in independent claim 8. Respective preferred embodiments thereof are respectively defined in the respective following subclaims. A computer program product according to the present invention is defined in claim 12.

Therefore, according to the present invention a filter, preferably a digital filter, is provided whose bandwidth can be easily tuned continuously and which can be optimally adjusted to the actual reception situation or some other motivated necessity. It is a linear filter as it consists of a single sideband filter, two mixers and one lowpass and therefore needs a comparatively low calculation power.

The basic idea is to filter both frequency ranges of the real valued signal, i. e. the range above a wanted bandwidth frequency f_{b} and below a wanted bandwidth frequency -f_{b}, in an effective way at the same time. Therefore, the signal is reduced to one sideband in advance before the single sideband signal or vestigal single sideband signal is shifted in the frequency domain and one lowpass filter with a fixed bandwidth, e. g. a fixed cut-off-frequency, is used to filter both frequency ranges of the real valued signal simultaneously. Therewith, the bandwidth of the overall filtering can be changed by simply adjusting the frequency shift.

Preferrably, the filter according to the present invention further comprises a real value determination unit to build the real value of the output signal of the second frequency shifter as output signal of said filter. Further preferrably, in a preferrably digital realization of the filter according to the present invention said real value determination is performed by said second frequency shifter in that this unit only determines the frequency shifted real part of its input signal.

Also, according to the present invention, said first frequency shifter, said filter unit and said second frequency shifter might be complex devices.

In particular in case these both embodiments are combined a very effective decrease of calculation power can be achieved, in particular when the filter according to the present invention is realized on a digital signal processor (DSP), since the sampling rate of the complex output signal of the single sideband reduction unit can be reduced due to its limited bandwidth and an upsampling needs only to be performed on the real signal determined by the real value determination unit.

Also of particular advantage in case of a DSP realization is a realization according to which said filter unit comprises a finite impulse response (fir) lowpass filter, since in this way a linear system with a linear phase is obtained which shows no problems in respect to stability.

Alternatively or additionally to the above described features said single sideband reduction unit of the filter according to the present invention comprises: a Hilbert-filter receiving the input received broadcast signal to determine an imaginary part of said single sideband signal, and a delay element delaying the input received broadcast signal so that a group delay of said Hilbert-filter is compensated to determine a real part of said single sideband signal.

Alternatively to this solution wherein the upper sideband is used, also the lower sideband might be used instead. In this case a multiplication of the output signal of the Hilbert-filter with -1 has to be performed additionally.

Also in this case of particular advantage in case of a DSP realization is a realization according to which said Hilbert-filter comprises a fir filter.

A filter according to the present invention is preferrably used for filtering received broadcast signals.

The method according to the present invention is therefore further preferrably, characterized in that said reduction of the received broadcast signal to a single sideband thereof is performed using a Hilbert-transform.

Further, the method according to the present invention might be characterized by a determination of the real value of the frequency shifted, filtered, and frequency shift and group delay compensated signal.

Still further, in the method according to the present invention said signal to be filtered might be a received broadcast signal.

Additionally, a computer program product according to the present invention comprises computer program means adapted to perform the method steps as defined above when it is executed on a computer or digital signal processor.

Further features, objects and advantages of the filter and the method according to the present invention will be better understood from the following detailed description of an exemplary embodiment thereof taken in conjunction with the accompanying drawings, wherein
- **Fig. 1**: shows a block diagram of a digital filter according to a preferred embodiment of the invention
- **Fig. 2**: shows different signals occurring in the signal flow of the digital filter shown in Fig. 1, and
- **Fig. 3**: shows a possible transfer function of a Hilbert-transform used in the filter shown in Fig. 1.

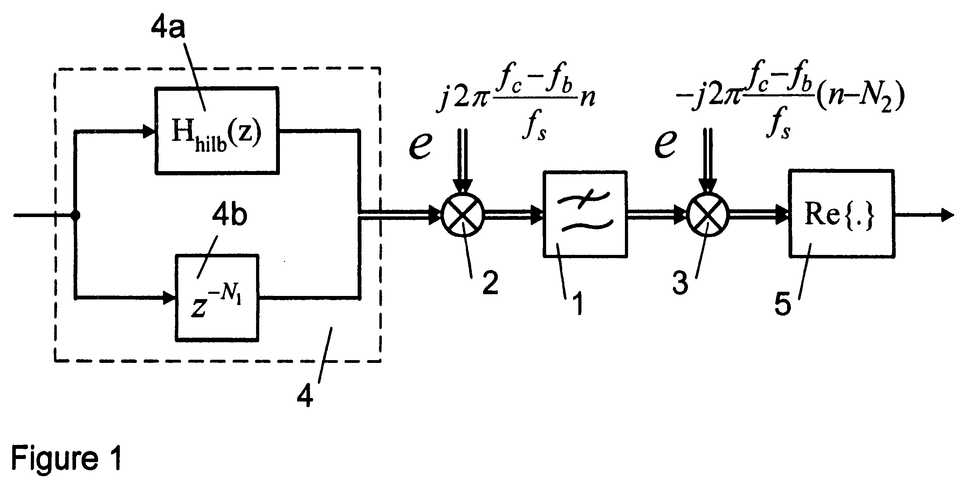

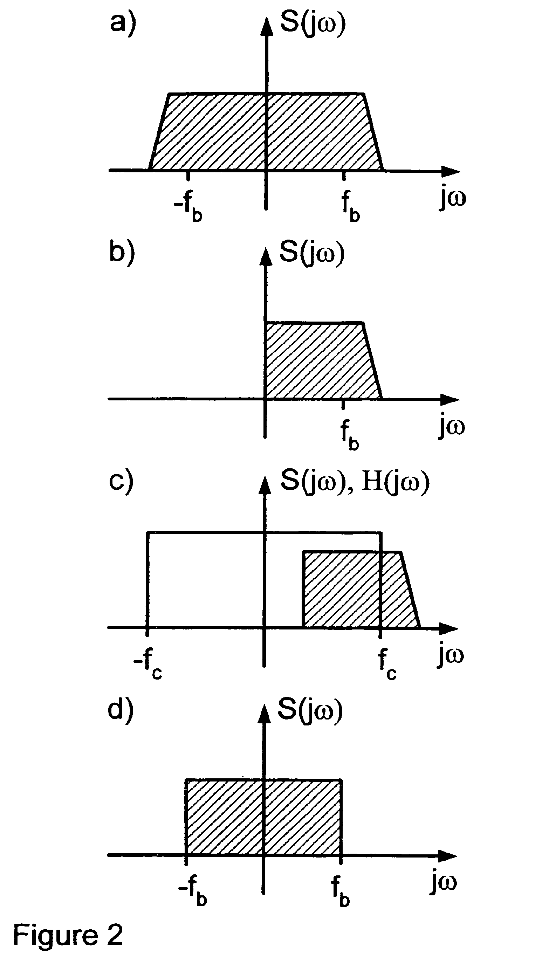

In Fig. 1 the real valued input signal shown in Fig. 2 a) that shall be lowpass filtered with a bandwidth f_{b} is input to a single sideband reduction unit 4 to be reduced to one sideband. The resulting single sideband signal which is shown in Fig. 2 b) is input to a first frequency shifter 2 which is connected to the output of the single sideband reduction unit 4 to be shifted in the frequency domain by f_{c}-f_{b} so that f_{b} matches f_{c} which is cut-off-frequency of the lowpass filter 1 which is connected to the output of the first frequency shifter 2. The frequency shifted single sideband signal and the transfer function of the lowpass filter 1 are shown in Fig. 2 c). After the lowpass filtering the signal is shifted back by a second frequency shifter 3 which compensates the first frequency shift and the group delay N₂ of the lowpass filter 1. By determining the real part of the resulting signal the wanted real valued signal reduced to the bandwidth f_{b} is gained, as it is shown in Fig. 2 d). In this way, according to the present invention the bandwidth can be tuned very easily just by changing one parameter, i. e. the bandwidth f_{b}.

The single sideband reduction unit 4 shown in Fig. 1 comprises a Hilbert-filter 4a, i.e. a real filter, which receives the real valued input signal and which output signal represents the imaginary part of the single sideband signal. Further, the real valued input signal which undergoes a delay of N₁ in a delay element 4b, which delay N₁ equals to the group delay of the Hilbert-filter 4a, provides the real part of the single sideband signal. In the above description the upper sideband is used to perform the filtering. Of course, as mentioned above, instead the lower sideband can be used as well. In this case a multiplication of the output signal of the Hilbert-filter with -1 has to be performed additionally and the frequency shifts have to be realized in the opposite direction, respectively.

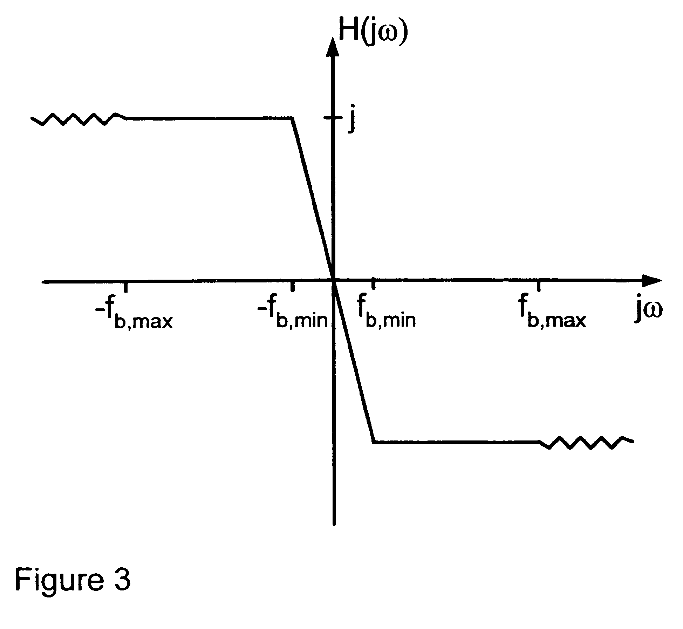

According to the present invention the requirements for the transfer function of the Hilbert-filter are very relaxed. It is not necessary to have a pure single sideband signal, it is sufficient to have a vestigial sideband signal which requires only shorter filters for the Hilbert-transform. If there is a minimum bandwidth I ±f_{b.min}| defined for the tunable filter the transition band can exploit the whole range from -f_{b.min} up to f_{b.min}, as it is shown in Fig. 3. Moreover, as also shown in Fig. 3, ripples above a defined maximum bandwidth |±f_{b.max}|, i.e. below - f_{b.max} and/or above f_{b.max} with |±f_{b.min}|<|±f_{b.max}|, can be accepted.

Further, as also mentioned above, it is possible to subsample the single sideband signal due to its reduced bandwidth before shifting. Therefore, a sharper lowpass filtering can be applied and/or the calculation power for the mixers and the lowpass is reduced. The corresponding up-sampling can be done on the real valued output signal, i.e. after frequency shift, actual filtering and frequency shift and filter group delay compensation.

According to the present invention the filter system is linear and has a linear phase, as no IIR-filters need to be used. The filter can be easily implemented on a digital signal processor as no IIR-filters are used which could cause problems in fixed point implementations. The Hilbert-transform and the lowpass can be realized as fir filters that are very convenient and effective for DSP realization.

The characteristic of the overall filter transfer function is only determined by the lowpass filter 1 which can be designed in terms of the required suppression characteristic very easily.

Therefore, in comparison with the above-identified European Patent Application 00 110 526.1 calculation power is reduced, since according to the present invention both signal transition sides of the signal are filtered in one "expensive" filter step, which needs an overall lower calculation power than the sum of the filter steps necessary according to the European Patent Application 00 110 526.1. In particular, the present invention is tailored to a digital baseband system for real valued baseband signals, in particular for a digital AM receiver, whereas the before discussed European Patent Application 00 110 526.1 is tailored to an analog system for real valued IF-signals.

The above embodiment of the present invention is described with respect to real valued input signals where the single sideband transform causes no information losses. However, the present invention is not restricted thereto, but is also applicable to complex baseband signals. In this case the less disturbed sideband should be used for the filtering.

## Claims

1. Filter having a tunable bandwidth, comprising:
- a filter unit (1) with a fixed bandwidth;
- a first frequency shifter (2) preceding said filter unit (1) to shift the signal to be filtered so that an unwanted signal part lies outside the passband of said filter unit (1); and
- a second frequency shifter (3) succeeding said filter unit (1)and compensating the frequency shift introduced by said first frequency shifter (2)
**characterized by**
said second frequency shifter (3) being arranged to take a group delay (N₂) introduced by said filter unit (1) into consideration; and
- a single sideband reduction unit (4) arranged to received a real valued input signal, to output a complex single sideband signal and to reduce said complex single sideband signal as a signal to be filtered to a single sideband or vestigial single sideband thereof before it is input to said first frequency shifter (2).

2. Filter according to claim 1, **characterized by** a real value determination unit (5) to build the real value of the output signal of the second frequency shifter (3) as output signal of said filter or in that said second frequency shifter (3) only determines the real part of its frequency shifted input signal.

3. Filter according to claim 1 or 2, **characterized in that** said first frequency shifter (2) said filter unit (1) and said second frequency shifter (3) are complex devices.

4. Filter according to anyone of the preceding claims, **characterized in that** said filter unit (1) comprises a fir lowpass filter.

5. Filter according to anyone of the preceding claims, **characterized in that** said single sideband reduction unit (4) comprises:
- a Hilbert-filter (4a) receiving the input received broadcast signal to determine an imaginary part of said single signal; and
- a delay element (4b) delaying the input received broadcast signal so that a group delay of said Hilbert-filter (4a) is compensated to determine a real part of said single sideband signal.

6. Filter according to claim 5, **characterized in that** said Hilbert-filter (4a) comprises a fir filter.

7. Use of a filter according to anyone of claims 1 to 6 for filtering received broadcast signals.

8. Method to perform a tunable bandwidth filtering, wherein
- a signal to be filtered gets frequency shifted so that an unwanted signal part lies outside the passband of a filter unit (1) with fixed bandwidth;
- the frequency shifted signal gets filtered with said fixed bandwidth; and
- the introduced frequency shift (f_{c}-f_{b})gets taken into consideration,
**characterized in that**
- a group delay (N₂) introduced by said filtering gets taken into consideration;
- said signal to be filtered is a complex single sideband signal; and
- a reduction of said signal to be filtered to a single sideband or vestigial single sideband thereof is performed before said frequency shifting.

9. Method according to claim 8, **characterized in that** said reduction of the received broadcast signal sideband thereof is performed using a Hilbert-transform.

10. Method according to claim 8 or 9, **characterized by** a determination of the real value of frequency shifted, filtered, and frequency shift and group delay compensated signal.

11. Method according to anyone of claims 8 to 10, **characterized in that** said signal to be filtered is a received broadcast signal.

12. Computer program product, comprising computer means adapted to perform the method steps as defined in anyone of claims 8 to 11 when it is executed on a computer or digital signal processor.

## Patentansprüche

1. Filter mit abstimmbarer Bandbreite, mit:
- einer Filtereinheit (1) mit einer festen Bandbreite;
- einem ersten Frequenzschieber (2), der der Filtereinheit (1) vorangeht, um das zu filternde Signal so zu filtern, dass ein nicht gewollter Signalteil außerhalb des Durchlassbands der Filtereinheit (1) liegt; und
- einem zweiten Frequenzschieber (3), der der Filtereinheit (1) nachfolgt und die durch den ersten Frequenzschieber (2) eingeführte Frequenzverschiebung kompensiert;
**gekennzeichnet durch**
- eine Anordnung des zweiten Frequenzschiebers (3) so, dass er eine **durch** die Filtereinheit (1) eingeführte Gruppenverzögerung (N₂) berücksichtigt; und
- eine Einzelseitenband-Reduktionseinheit (4), die dazu angeordnet ist, ein realwertiges Eingangssignal zu empfangen, ein komplexes Einzelseitenbandsignal auszugeben und das komplexe Einzelseitenbandsignal als ein zu filterndes Signal auf ein Einzelseitenband oder ein verkümmertes Einzelseitenband desselben zu reduzieren, bevor es in den ersten Frequenzschieber (2) eingeleitet wird.

2. Filter nach Anspruch 1, **gekennzeichnet durch** eine Realwert-Bestimmungseinheit (5) zum Bilden des Realwerts des Ausgangssignals des zweiten Frequenzschiebers (3) als Ausgangssignal des Filters, oder **dadurch, dass** der zweite Frequenzschieber (3) nur den Realteil seines frequenzverschobenen Eingangssignals bestimmt.

3. Filter nach Anspruch 1 oder 2, **dadurch gekennzeichnet, dass** der erste Frequenzschieber (2), die Filtereinheit (1) und der zweite Frequenzschieber (3) komplexe Einrichtungen sind.

4. Filter nach einem der vorangehenden Ansprüche, **dadurch gekennzeichnet, dass** die Filtereinheit (1) ein FIR-Tiefpassfilter enthält.

5. Filter nach einem der vorangehenden Ansprüche, **dadurch gekennzeichnet, dass** die Einzelseitenband-Reduktionseinheit (4) enthält:
- ein Hilbert-Filter (4a), das das zugeführte Rundfunksignal empfängt, um einen Imaginärteil des Einzelseitenbandsignals zu bestimmen; und
- ein Verzögerungselement (4b), das das zugeführte Rundfunksignal so verzögert, dass eine Gruppenverzögerung des Hilbert-Filters (4a) kompensiert wird, um einen Realteil des Einzelseitenbandsignals zu bestimmen.

6. Filter nach Anspruch 5, **dadurch gekennzeichnet, dass** das Hilbert-Filter (4a) ein FIR-Filter enthält.

7. Verwendung eines Filters nach einem der Ansprüche 1 bis 6 zum Filtern empfangener Rundfunksignale.

8. Verfahren zum Durchführen einer Filterung mit abstimmbarer Bandbreite, bei dem
- ein zu filterndes Signal so frequenzverschoben wird, dass ein nicht gewollter Signalteil außerhalb des Durchlassbands einer Filtereinheit (1) mit fester Bandbreite liegt;
- das frequenzverschobene Signal mit der festen Bandbreite gefiltert wird; und
- die eingeführte Frequenzverschiebung (f_{c} - f_{b}) berücksichtigt wird;
**dadurch gekennzeichnet, dass**
- eine durch die Filterung eingeführte Gruppenverzögerung (N₂) berücksichtigt;
- das zu filternde Signal ein komplexes Einzelseitenbandsignal ist; und
- eine Reduktion des zu filternden Signals auf ein Einzelseitenband oder ein verkümmertes Einzelseitenband desselben vor der Frequenzverschiebung durchgeführt wird.

9. Verfahren nach Anspruch 8, **dadurch gekennzeichnet, dass** die Reduktion des empfangenen Rundfunksignal-Seitenbands desselben unter Verwendung einer Hilbert-Transformation durchgeführt wird.

10. Verfahren nach Anspruch 8 oder 9, **gekennzeichnet durch** eine Bestimmung des Realwerts des frequenzverschobenen, gefilterten, und frequenzverschobenen und gruppenverzögerungskompensierten Signals.

11. Verfahren nach einem der Ansprüche 8 bis 10, **dadurch gekennzeichnet, dass** das zu filternde Signal ein empfangenes Rundfunksignal ist.

12. Computerprogrammprodukt, mit einer Computereinrichtung, die dazu ausgelegt ist, die Verfahrensschritte wie in einem der Ansprüche 8 bis 11 durchzuführen, wenn sie auf einem Computer oder einem digitalen Signalprozessor ausgeführt wird.

## Revendications

1. Filtre ayant une largeur de bande réglable comprenant :
- une unité de filtre (1) ayant une largeur de bande fixe,
- un premier module de décalage de fréquence (2) précédant ladite unité de filtre (1) pour décaler le signal devant être filtré de sorte qu'une partie de signal non souhaitée se situe en dehors de la bande passante de ladite unité de filtre (1), et
- un deuxième module de décalage de fréquence (3) suivant ladite unité de filtre (1) et compensant le décalage de fréquence introduit par ledit premier module de décalage de fréquence (2),
**caractérisé par le fait que**
ledit deuxième module de décalage de fréquence (3) est conçu pour prendre en considération un retard de groupe (N₂) introduit par ladite unité de filtre (1), et
- une unité de réduction de bande latérale unique (4) conçue pour recevoir un signal d'entrée à valeur réelle, pour fournir en sortie un signal de bande latérale unique complexe et pour réduire ledit signal de bande latérale unique complexe en tant que signal devant être filtré à une bande latérale unique ou bien à une bande latérale atténuée unique de celui-ci avant qu'il ne soit appliqué en entrée audit premier module de décalage de fréquence (2).

2. Filtre selon la revendication 1, **caractérisé par** une unité de détermination de valeur réelle (5) destinée à construire la valeur réelle du signal de sortie du deuxième module de décalage de fréquence (3) en tant que signal de sortie dudit filtre, ou en ce que ledit deuxième module de décalage de fréquence (3) ne détermine que la partie réelle de son signal d'entrée décalé en fréquence.

3. Filtre selon la revendication 1 ou 2, **caractérisé en ce que** ledit premier module de décalage de fréquence (2), ladite unité de filtre (1) et ledit deuxième module de décalage de fréquence (3) sont des dispositifs complexes.

4. Filtre selon l'une quelconque des revendications précédentes, **caractérisé en ce que** ladite unité de filtre (1) comprend un filtre passe-bas à réponse impulsionnelle finie.

5. Filtre selon l'une quelconque des revendications précédentes, **caractérisé en ce que** ladite unité de réduction de bande latérale unique (4) comprend :
- un filtre de Hilbert (4a) recevant le signal diffusé reçu appliqué en entrée pour déterminer une partie imaginaire dudit signal unique, et
- un élément à retard (4b) retardant le signal diffusé reçu appliqué en entrée de sorte qu'un retard de groupe dudit filtre de Hilbert (4a) est compensé pour déterminer une partie réelle dudit signal de bande latérale unique.

6. Filtre selon la revendication 5, **caractérisé en ce que** ledit filtre de Hilbert (4a) comprend un filtre à réponse impulsionnelle finie.

7. Utilisation d'un filtre selon l'une quelconque des revendications 1 à 6 pour filtrer des signaux diffusés reçus.

8. Procédé destiné à exécuter un filtrage à largeur de bande réglable, dans lequel
- un signal devant être filtré est décalé en fréquence de sorte qu'une partie du signal non souhaitée soit située en dehors de la bande passante d'une unité de filtre (1) ayant une largeur de bande fixe,
- le signal décalé en fréquence est filtré par le biais de ladite largeur de bande fixe, et
- le décalage en fréquence introduit (f_{c}-f_{b}) est pris en considération,
**caractérisé en ce que**
- un retard de groupe (N₂) introduit par ledit filtrage est pris en considération,
- ledit signal à filtrer est un signal de bande latérale unique complexe, et
- une réduction dudit signal devant être filtré à une bande latérale unique ou à une bande latérale atténuée unique de celui-ci est exécutée avant ledit décalage de fréquence.

9. Procédé selon la revendication 8, **caractérisé en ce que** ladite réduction de sa bande latérale de signal diffusé reçu est exécutée en utilisant une transformation de Hilbert.

10. Procédé selon la revendication 8 ou 9, **caractérisé par** une détermination de la valeur réelle du signal décalé en fréquence, filtré, et ayant fait l'objet d'une compensation de décalage de fréquence et de retard de groupe.

11. Procédé selon l'une quelconque des revendications 8 à 10, **caractérisé en ce que** ledit signal devant être filtré est un signal diffusé reçu.

12. Produit de programme informatique comprenant un moyen informatique conçu pour exécuter les étapes de procédé telles que définies dans l'une quelconque des revendications 8 à 11, lorsqu'il est exécuté sur un ordinateur ou un processeur de signal numérique.
